# EUROPÄISCHE PATENTSCHRIFT

(11) **EP 0 317 848 B1**
(45) Veröffentlichungstag und Bekanntmachung des Hinweises auf die Patenterteilung: **09.06.1993**
(21) Anmeldenummer: 88118841.1
(22) Anmeldetag: 11.11.1988
(51) Int. Cl.: H02B 1/26

(54) **Gehäusemodul für elektrische Baugruppen und/oder Anschlussvorrichtungen**
Casing for electrical modules and/or connection devices
Boîtier pour modules électriques et/ou dispositifs de raccordement

(30) Priorität: 23.11.1987 DE 8715506 U
(43) Veröffentlichungstag der Anmeldung: 31.05.1989
(73) Patentinhaber: Siemens Nixdorf Informationssysteme Aktiengesellschaft, 33102 Paderborn (DE)
(72) Erfinder: Claes, Norbert, D-3490 Bad Driburg (DE); Klösener, Franz, D-4790 Paderborn (DE); Knoop, Franz-Josef, D-4793 Büren-Steinhausen (DE)
(74) Vertreter: Fuchs, Franz-Josef, Dr.-Ing.

(56) Entgegenhaltungen:
- DE-B- 1 063 679
- DE-U- 7 623 623
- US-A- 3 997 819

## Beschreibung

Die Erfindung betrifft ein Gehäusemodul für elektrische Baugruppen und/oder Anschlußvorrichtungen, mit einem quaderförmigen Rahmenteil und mehreren an dem Rahmenteil zu befestigenden Wänden, wobei das Rahmenteil mindestens zwei an der Innenseite diagonal einander gegenüber liegender Kanten parallel zu diesen liegende Durchstecköffnungen zur Aufnahme jeweils eines Verbindungselementes zur Verbindung mit einem weiteren Rahmenteil und/oder zur Befestigung einer Wand aufweist.

Ein Gehäusemodul dieser Art bildet eine Baueinheit, die mit anderen, gleichartigen Gehäusemodulen verbunden werden kann, wodurch sich ein besonderes die Gehäusemodule verbindendes Rahmengestell erübrigt. Hierzu sind bei einer aus der DE-B 10 63 679 bekannten Konstruktion als Verbindungselemente Gewindebolzen vorgesehen, mit denen zwischen den einzelnen Gehäusemodulen eine Schraubverbindung hergestellt wird. Zum Anschluß an einen benachbarten Gehäusemodul hat der jeweilige Gewindebolzen einen Kopf mit Innengewinde, in das der jeweils nächstfolgende Gewindebolzen eingeschraubt werden kann.

Dieser Gehäuseaufbau aus Einzelmodulen, die aneinandergereiht werden, besteht aus ringförmig geschlossenen Rahmenteilen und ist dazu bestimmt, elektrische Anschluß- oder Verteilungseinrichtungen aufzunehmen, die bleibend zu installieren und praktisch wartungsfrei sind. Eine Verwendung für elektrische Baugruppen, die regelmäßig zu warten sind oder bei denen eine Veränderung bzw. Erweiterung ihres Aufbaus möglich ist, würde zu umständlichen zusätzlichen Montagearbeiten führen, sobald ein Eingriff in eine Baugruppe erforderlich wäre.

Es ist Aufgabe der Erfindung, eine Konstruktion für ein Gehäusemodul anzugeben, durch die es möglich ist, mehrere Gehäusemodule aneinanderzureihen und in ihnen untergebrachte Einrichtungen ohne Störung des Gehäuseaufbaus zugänglich zu halten.

Ein Gehäusemodul der eingangs genannten Art ist zur Lösung dieser Aufgabe erfindungsgemäß derart ausgebildet, daß das Rahmenteil quer zu den Durchstecköffnungen zueinander parallele innere Führungen für mindestens eine Einschubeinheit enthält, und daß an mindestens einer der parallel zu den Durchstecköffnungen liegenden Kanten des Rahmenteils mindestens eine Seitenwand zwischen einer Öffnungsstellung und einer Verschlußstellung klappbar angelenkt ist.

Durch die Erfindung ist es möglich, ein Gehäuse für elektrische Baugruppen und/oder Anschlußvorrichtungen aus aneinandergereihten Einzelmodulen aufzubauen und jedes dieser Gehäuseabteile individuell zugänglich zu halten, ohne das Gehäuse hierzu demontieren zu müssen. Die Ausbildung der jeweiligen Seitenwand als Klappwand ermöglicht einen besonders schnellen Zugang zum Inneren des Gehäusemoduls, ohne sie vollständig entfernen zu müssen. Dies wäre im Hinblick auf die hier angewendete Einschubtechnik zu umständlich. Die Erfindung bringt besondere Vorteile bei Anschlußgehäusen für Schwachstrom- bzw. Fernmeldeanlagen unterschiedlicher Art, denn es ist möglich, Anschlußschaltungen für Fernsprechen, Datenverarbeitung, Fernschreiben u.s.w. in einem Gehäuse zusammenzufassen und individuell zugänglich zu halten.

Aus der DE-U-76 23 623 ist zwar ein Gehäusemodul mit Führungen für Einschubeinheiten bekannt, jedoch sind diese Führungen nicht quer, sondern parallel zu gleichfalls vorgesehenen Durchstecköffnungen angeordnet. Deshalb kann diese Konstruktion die vorstehend genannte Aufgabenstellung nicht lösen. Auch ist aus der US-A-3 997 819 ein Gehäusemodul bekannt, dessen Vorder- und Rückseitenwand klappbar angelenkt sind. Hier ist aber keine Möglichkeit der Aneinanderreihung mehrerer Einzelmodule mit in Durchstecköffnungen geführten Verbindungselementen vorgesehen.

Zweckmäßig ist in dem Rahmenteil quer zu den inneren Führungen eine Verdrahtungswand für die Einschubeinheit vorgesehen. Sie kann Steckerteile tragen, die zur Steckverbindung mit der jeweiligen Einschubeinheit dienen.

Ein besonders vorteilhafter Gehäuseaufbau ist möglich, wenn zwei einander gegenüber liegende Seitenwände klappbar angelenkt sind, denn dies bietet den schnellen Zugang zum Inneren des Gehäusemoduls von zwei Außenseiten her, wobei dann auf der einen Seite z.B. Schaltungsplatinen auswechselbar sind und auf der anderen Seite Beschaltungen von Steckerleisten möglich sind, in die die Schaltungsplatinen einzuschieben sind.

Wenn klappbare Seitenwände vorgesehen sind, so sind diese in ihrer Schließstellung auf geeignete Weise mit dem Rahmenteil zu verbinden, wozu sich üblicherweise eine Rastverbindung oder auch eine Schraubverbindung anbietet. Eine besonders vorteilhafte Weiterbildung des Gehäusemoduls zeichnet sich aber dadurch aus, daß die klappbare Seitenwand ein U-förmiges Profil hat, dessen quer zu den Durchstecköffnungen liegende Schenkel fluchtende Öffnungen haben, in denen ein Schieber gegen Federkraft verschieblich angeordnet ist, und daß eine quer zu den Durchstecköffnungen zu befestigende Wand eine dem jeweiligen Schieber entsprechend ausgebildete und angeordnete Öffnung enthält, während eine andere quer zu den Durchstecköffnungen zu befestigende Wand in entsprechender Anordnung je eine in Schieberichtung wirkende Schließvorrichtung trägt.

Durch diese Weiterbildung ist es möglich, die jeweilige klappbare Seitenwand in ihrer Schließstellung ohne Rast- oder Schraubverbindung zu fixieren, denn wenn die mit den Schließvorrichtungen versehene Abschlußwand montiert wird, stehen die Schließvorrichtungen den in den klappbaren Seitenwänden vorgesehenen Schiebern gegenüber, und wenn die jeweilige Schließvorrichtung in Schließstellung gebracht wird, so wird dadurch der ihr zugeordnete Schieber so in Richtung zur anderen Abschlußwand hin verschoben, daß er in deren Öffnung liegt. Auf diese Weise wird die jeweilige klappbare Seitenwand einerseits durch den Schieber, andererseits durch die den Schieber verschiebende Schließvorrichtung in ihrer Lage sicher fixiert. Wenn nun mehrere Gehäusemodule miteinander verbunden sind, so ergibt sich eine gleichartige Fixierung aller miteinander fluchtenden klappbaren Seitenwände, denn es bildet sich dabei eine Aneinanderreihung mehrerer Schieber, die sich, veranlaßt durch die jeweilige Schließvorrichtung am Ende dieser Kette, in Richtung ihrer Längsachse verschieben, bis der Schieber am anderen Ende dieser Kette in die ihm zugeordnete Öffnung der dort vorgesehenen Abschlußwand des Gesamtgehäuses gelangt.

Vorteilhaft kann bei diesem Verschlußprinzip der klappbaren Seitenwände auch noch die jeweilige Abschlußwand in ihrer Lage fixiert werden.

Die Anwendung des Modularitätsprinzips erstreckt sich auch auf solche Gehäuse, die an besonderen Trägern zu montieren sind, z.B. im Rahmen einer Installation an Wänden zu befestigende Gehäuse. Solche Gehäuse sind beispielsweise Anschlußgehäuse für Datenendgeräte, Fernsprechteilnehmerstationen usw. Je nach mit der Installation zu verbindendem Gerät ist ein mehr oder weniger großes Anschlußgehäuse erforderlich, in dem nicht nur Anschlußelemente, sondern oft auch elektronische Baugruppen unterzubringen sind. In diesem Fall ist das Gehäusemodul vorteilhaft derart ausgebildet, daß eine quer zu den Durchstecköffnungen zu befestigende Wand als eine Montagewand ausgebildet ist. Eine solche Montagewand kann als Trägerelement einen oder mehrere miteinander verbundene Gehäusemodule tragen und ist in an sich bekannter Weise mit Montageelementen versehen. Durch ein besonderes Profil in Verbindung mit Durchtrittsöffnungen ermöglicht sie das bequeme Einführen von Leitungen in das mit ihr unmittelbar verbundene Gehäusemodul.

Wenn die Verbindungselemente der Gehäusemodule Gewindebolzen sind, die auch zur Befestigung von Abschlußwänden des Gesamtgehäuses genutzt werden sollen, so wird dies in einer Weiterbildung der Erfindung besonders vorteilhaft dadurch verwirklicht, daß quer zu den Durchstecköffnungen zu befestigende Wände an ihrer Innenseite in einer derjenigen der Durchstecköffnungen entsprechenden Anordnung mit Gewindeelementen ausgerüstet oder ausrüstbar sind. Solche Gewindeelemente können z.B. an der Innenseite der jeweiligen Wand gehaltene Schrauben bzw. Muttern sein, die im einfachsten Fall dadurch zugänglich sind, daß die jeweilige Wand mit entsprechenden, relativ kleinen Öffnungen versehen ist, die lediglich den Durchtritt eines Werkzeuges gestatten müssen. Es ist aber auch möglich, Gewindeelemente zum Befestigen von Abschlußwänden von außen her durch entsprechende Öffnungen einzuführen und mit den freiliegenden Enden der Gewindebolzen zu verbinden, wenn solche Schrauben bzw. Muttern nach außen hin freiliegen dürfen.

Ein besonders vorteilhaftes Montieren von Abschlußwänden ist dann möglich, wenn die quer zu den Durchstecköffnungen zu befestigenden Wände an ihrer Innenseite klauenartige Halter für Gewindeelemente tragen, deren Klauenöffnungen übereinstimmend ausgerichtet sind. Dadurch wird eine Möglichkeit der Befestigung von Abschlußwänden eröffnet, die keiner von außen zugänglicher Gewindeelemente bedarf. Es ist dabei so vorzugehen, daß die Gewindeelemente, also Schrauben bzw. Muttern, zunächst auf das jeweils freiliegende Ende eines Gewindebolzens aufgeschraubt werden und dann die jeweilige Abschlußwand mit ihren klauenartigen Haltern durch eine quer zu der Längsachse der Gewindeelemente gerichtete Bewegung aufgeschoben wird. Wenn die Gewindeelemente eine geeignete Länge haben, so wird dabei ein zuverlässiger und fester Sitz der jeweiligen Abschlußwand an ihrem Gehäusemodul verwirklicht.

Bei Gewindebolzen als Verbindungselemente, in deren Kopf ein Innengewinde vorgesehen ist, können nach dem eingangs erläuterten bekannten Prinzip die Gehäusemodule lückenlos aneinandergereiht werden. Dabei muß jedoch besonders die lockerungssichere Montage gewährleistet sein, damit nicht aus Gründen nachlassender Stabilität das Gehäuse demontiert werden muß. Um dies zu erreichen, haben bei einer Weiterbildung der Erfindung die Durchstecköffnungen erweiterte Enden, in die der Kopf des jeweiligen Gewindebolzens einsenkbar ist und darin mit einem Sicherungselement versehen werden kann. Vorteilhaft ist diese Art der Sicherung dann so verwirklicht, daß die Enden der als Innenvielkant ausgebildeten Durchstecköffnungen um die Dicke eines zylindrischen Sicherungselementes weiter als der Kopf der Gewindebolzen sind, und daß das Sicherungselement eine dem Kopf der Gewindebolzen entsprechende Innenkontur und eine dem Innenvielkant angepaßte Außenkontur hat. Dadurch ist es möglich, den jeweiligen Gewindebolzen zuerst mit einem in die Erweiterung der Durchstecköffnung passenden Werkzeug anzuziehen und anschließend das Sicherungselement auf seinen Kopf aufzustecken, wodurch die Verdrehsicherung sehr einfach bewerkstelligt wird.

Vorteilhaft hat das Sicherungselement eine Länge, die mindestens der doppelten Länge des erweiterten Endes der jeweiligen Durchstecköffnung entspricht. Es ragt dann aus der Durchstecköffnung des einen Gehäusemoduls heraus und in diejenige des benachbarten Gehäusemoduls hinein, wodurch bei der Montage die gegenseitige Ausrichtung der Gehäusemodule erleichtert wird. Ist das Sicherungselement länger als die doppelte Länge des erweiterten Endes der Durchstecköffnung, so erzeugt es einen Abstand zwischen benachbarten Gehäusemodulen, der zur Entlüftung erwünscht sein kann. In diesem Falle hat das Sicherungselement dann vorteilhaft in dem mittleren Abschnitt seiner Länge ein durchmessergrößeres flanschartiges Zylindersegment.

Ausführungsbeispiele der Erfindung werden im folgenden anhand der Figuren beschrieben. Es zeigen:
- Figur 1: eine Explosionsdarstellung des Aufbaus eines Gehäusemoduls für Wandmontage,
- Figur 2: eine Explosionsdarstellung eines freistehenden Gehäusemoduls,
- Figur 3: eine perspektivische Darstellung von Gewindeelementen in Zuordnung zu einem Rahmenteil,
- Figur 4: die Innenseite einer Wand des Gehäusemoduls nach Figur 1 bzw. Figur 2,
- Figur 5: den Schnitt V-V aus Figur 4,
- Figur 6: eine perspektivische Darstellung einer Seitenwand des Gehäusemoduls nach Figur 1 bzw. Figur 2,
- Figur 7: eine Schließvorrichtung für Wände des Gehäusemoduls in Öffnungsstellung,
- Figur 8: die Schließvorrichtung nach Figur 7 in Schließstellung und
- Figur 9: ein Rahmenteil des Gehäusemoduls nach Figur 1 bzw. nach Figur 2.

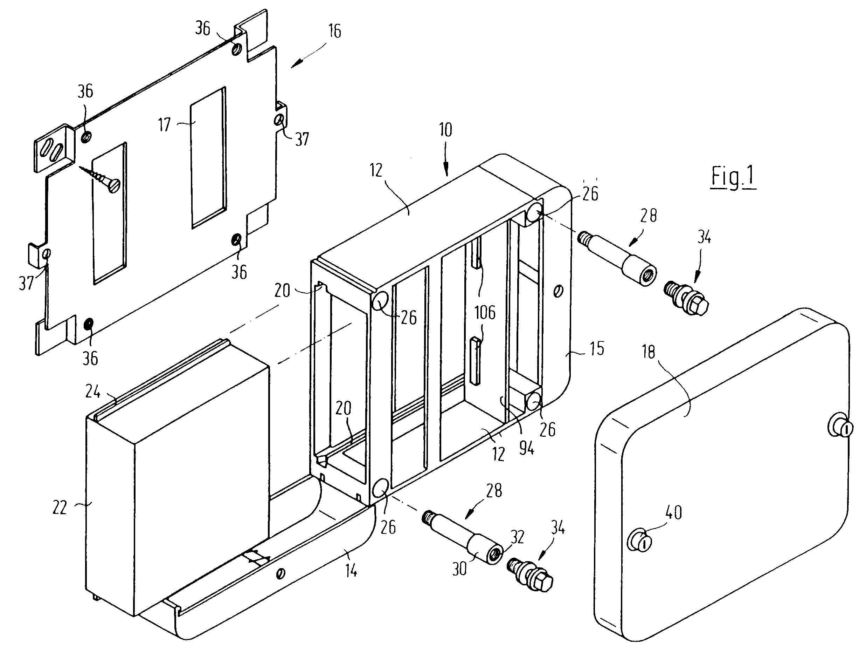

Figur 1 zeigt ein Gehäusemodul mit einem Rahmenteil 10, das an seinen einen Schmalseiten einander gegenüber liegende befestigte Seitenwände 12 und an den anderen beiden Schmalseiten zwei klappbar angelenkte Seitenwände 14, 15 aufweist. Die Seitenwand 14 befindet sich in Öffnungsstellung. Die Seitenwand 15 ist in Verschlußstellung dargestellt. Das Rahmenteil 10 ist in noch zu beschreibender Weise an einer in Figur 1 als Montagewand 16 für eine Wandbefestigung ausgebildeten Rückwand zu befestigen, während auf das Rahmenteil 10 in ebenfalls noch zu beschreibender Weise eine abgekantete Vorderwand 18 aufgesetzt werden kann. Auf der Innenseite der Seitenwände 12 sind Führungen 20 zum Führen einer Einschubeinheit 22 mit zu den Führungen 20 komplementären Führungsschienen 24 ausgebildet. Innerhalb der von den Seitenwänden 12 gebildeten Innenkanten hat das Rahmenteil 10 parallel zu diesen liegende Durchstecköffnungen 26. Sie dienen zur Aufnahme von davor abgebildeten Gewindebolzen 28, die in ihrem Kopf 30 ein Innengewinde 32 haben. In das Innengewinde 32 können Schrauben 34 eingeschraubt werden, die zur Befestigung der Vorderwand 18 dienen. Die Gewindeenden der in das Rahmenteil 10 eingesetzten Gewindebolzen 28 ragen über die Rückseite des Rahmenteils 10 hinaus und können mit in der Montagewand 16 vorgesehenen Innengewinden 36 verschraubt werden. Die Montagewand 16 wird mit dem Rahmenteil 10 auf diese Weise mechanisch stabil verbunden. An ihrem rechten und linken Rand besitzt die Montagewand 16 jeweils eine Durchbohrung 37, die mit auf der Vorderwand 18 befindlichen Schließmechanismen 40 parallel zu den Durchstecköffnungen 26 fluchten und die der Verriegelung der klappbaren Seitenwände 14, 15 in Verschlußstellung in noch zu beschreibender Weise dienen. Somit entspricht die Breite der Vorderwand 18 der Gesamtbreite des Gehäusemoduls bei anliegenden Seitenwänden 14, 15.

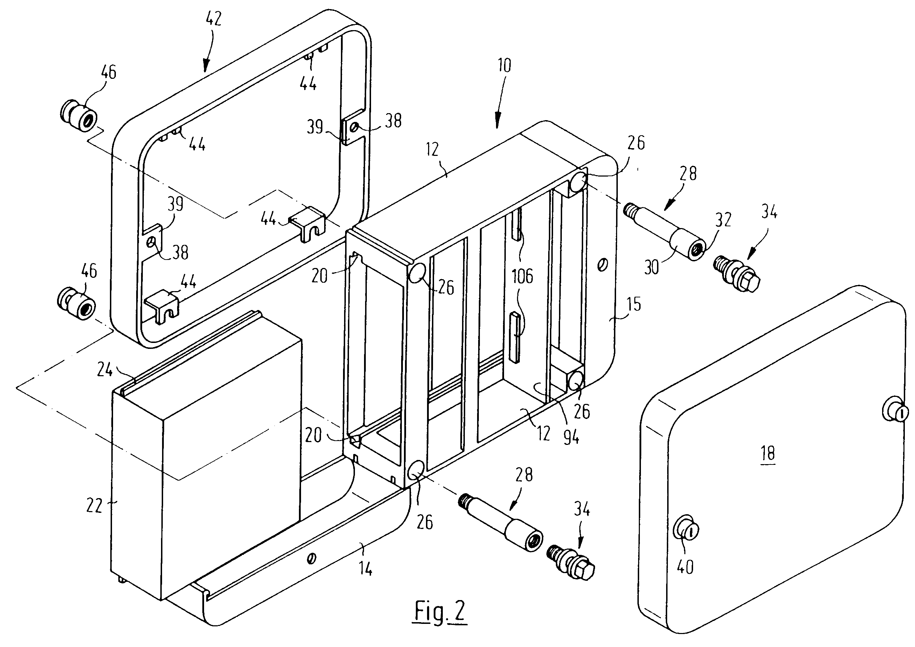

Figur 2 zeigt ein ähnliches Gehäusemodul wie in Figur 1 dargestellt, mit dem Unterschied, daß eine Rückwand 42 vorgesehen ist, die eine Nutzung als freistehendes Gehäusemodul gestattet. Diese Rückwand 42 ist gleichfalls abgekantet und trägt an ihrem Rand zwei nach innen stehende Laschen 39, die jeweils eine Durchbohrung 38 haben, die die gleiche Funktion wie die Durchbohrungen 37 der Montagewand 16 aus Figur 1 haben. Ferner hat die Rückwand 42 an ihrer Innenseite vier klauenförmige Halter 44 für die Aufnahme von Innengewindeköpfen 46. Die Halter 44 sind mit ihren Klauenöffnungen übereinstimmend ausgerichtet. Die im Rahmenteil 10 befindlichen Gewindebolzen 28 werden in die Innengewindeköpfe 46 eingeschraubt. Die Rückwand 42 kann durch eine Bewegung quer zu den Gewindebolzen 28 in Richtung der Klauenöffnungen der Halter 44 auf die Gewindeköpfe 46 aufgeschoben werden und ist dann mit dem Rahmenteil 10 verbunden.

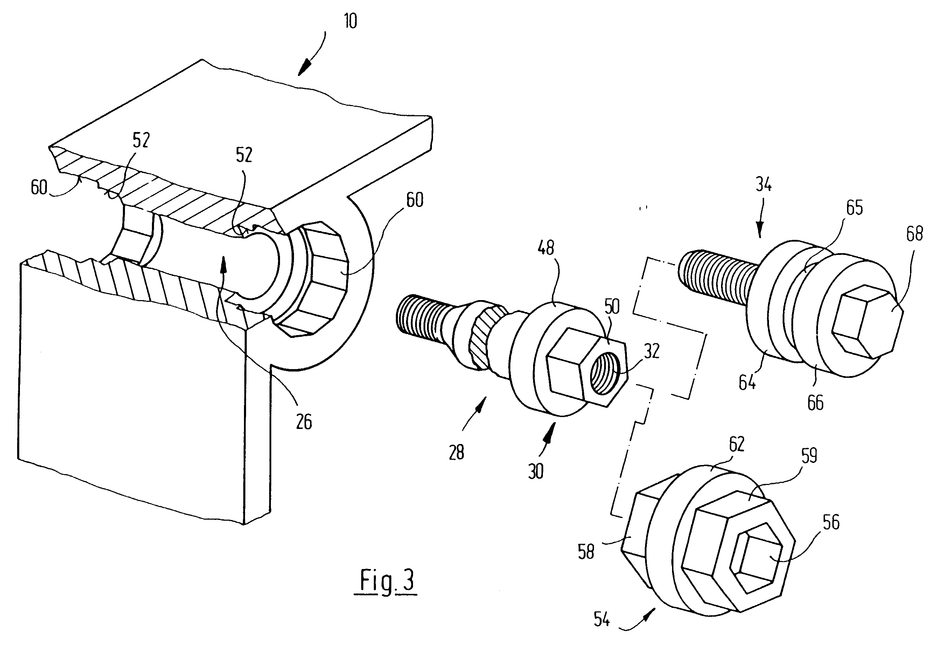

Figur 3 zeigt einen gebrochenen perspektivischen Teilausschnitt des Rahmenteils 10 mit einer Durchstecköffnung 26, die so ausgebildet ist, daß der Gewindebolzen 28 von zwei Seiten aus in die Durchstecköffnung 26 einzuführen ist. Der Innengewindekopf 30 des Gewindebolzens 28 besteht aus einem Zylindersegment 48 und einem Außensechskant 50. Der in die Durchstecköffnung 26 eingesetzte Gewindebolzen 28 liegt drehbar mit seinem Zylindersegment 48 in einem durchmesservergrößerten Bereich 52 der Durchstecköffnung 26. Nach dem Festschrauben des Rahmenteils 10 an einer Montagewand 16, einer Abschlußwand 42, oder einem weiteren Rahmenteil 10 wird der Gewindebolzen 28 gegen Verdrehen gesichert, indem auf den Außensechskant 50 des Gewindebolzens 28 ein Sicherungselement 54 aufgesetzt wird. Dieses hat einen Innensechskant 56, der komplementär zum Außensechskant 50 des Gewindebolzens 28 ist. Außerdem hat es an seinen beiden Enden einen Außensechskant 58, 59, der in einen Innenzwölfkant 60 der Durchstecköffnung 26 des Rahmenteils 10 eingreift und dadurch den Gewindebolzen 28 in seiner Lage gegen Verdrehen gesichert festhält. Das Sicherungselement 54 hat darüber hinaus zwischen den Sechskantabschnitten 58 und 59 ein Zylindersegment 62, welches einen definierten Abstand zwischen zwei Rahmenteilen 10 oder zwischen einem Rahmenteil 10 und einer Vorderwand 18 zu Lüftungszwecken gewährleistet. Zum Befestigen der Vorderwand 18 an dem Rahmenteil 10 ist eine Schraube 34 in das Innengewinde 32 des Gewindebolzens 28 durch das Sicherungselement 54 hindurch einschraubbar. Die Schraube 34 hat einen speziell ausgebildeten Kopf, bestehend aus drei Zylindersegmenten 64, 65, 66, von denen das mittlere Zylindersegment 65 gegenüber den beiden anderen Zylindersegmenten 64, 66 durchmesservermindert ist. Den Abschluß des Schraubenkopfes bildet ein Außensechskant 68, an dem ein Werkzeug angreifen kann.

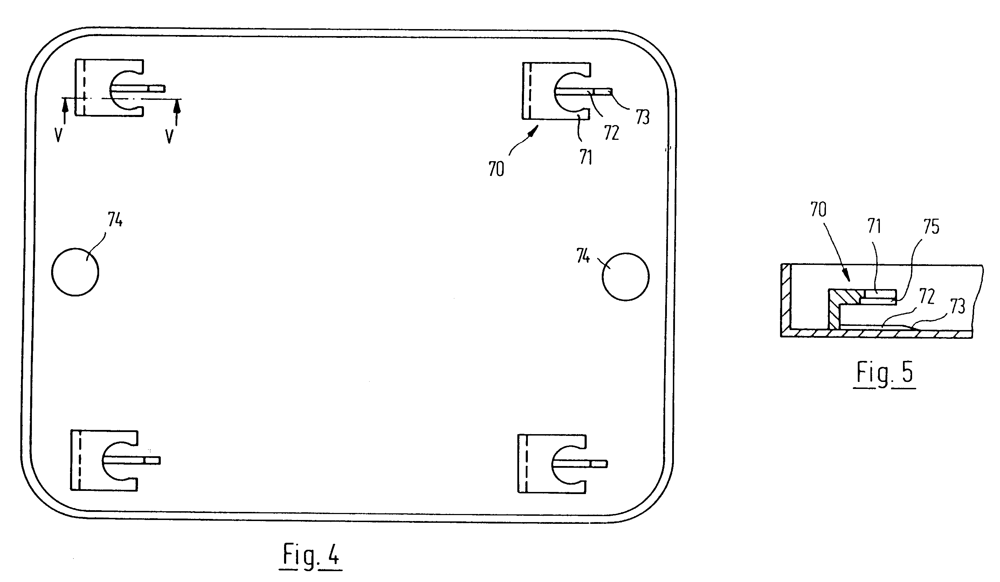

In Figur 4 ist die Innenseite der Vorderwand 18 dargestellt. Sie trägt in einer derjenigen der Schrauben 34 entsprechenden Anordnung vier klauenförmige Halter 70 (Figur 5), die in übereinstimmender Richtung geöffnet sind. Diese Halter 70 haben zwei Klauen 71. Die Vorderwand 18 wird zum Befestigen an einem Rahmenteil 10 quer zu den Durchstecköffnungen 26 auf gemäß Figur 3 in die Gewindebolzen 28 eingeschraubte Schrauben 34 aufgeschoben, was nachfolgend noch näher beschrieben wird. Jeweils ein Halter 70 hat auf der Innenseite der Vorderwand 18 eine Gleitfläche 72, die zur Klauenöffnung hin in einer Rampe 73 zur Oberfläche der Innenseite der Vorderwand 18 abfällt.

Auf der Innenseite der Vorderwand 18 sind in Figur 4 in axialer Richtung verschiebbare Schließbolzen 74 abgebildet, deren Funktion nachfolgend noch erklärt wird.

In Figur 5 ist der Schnitt V-V eines Halters 70 aus Figur 4 dargestellt. Die Klauen des Halters 70 sind in einen oberen Teil 71 und einen unteren Teil 75 unterteilt. Beim Aufschieben der Vorderwand 18 auf die Schrauben 34 quer zur Richtung der Gewindebolzen 28 umgreift das Klauenteil 71 das durchmesserverminderte Zylindersegment 65 der Schraube 34, und das Klauenteil 75 umgreift das durchmessergrößere Zylindersegment 66 der Schraube 34, während der Außensechskant 68 der Schraube 34 über die Rampe 73 auf die Gleitfläche 72 gleitet. Auf diese Weise wird der Kopf der Schraube 34 zwischen der Gleitfläche 72 und den Klauenteilen 71 und 75 fest verspannt.

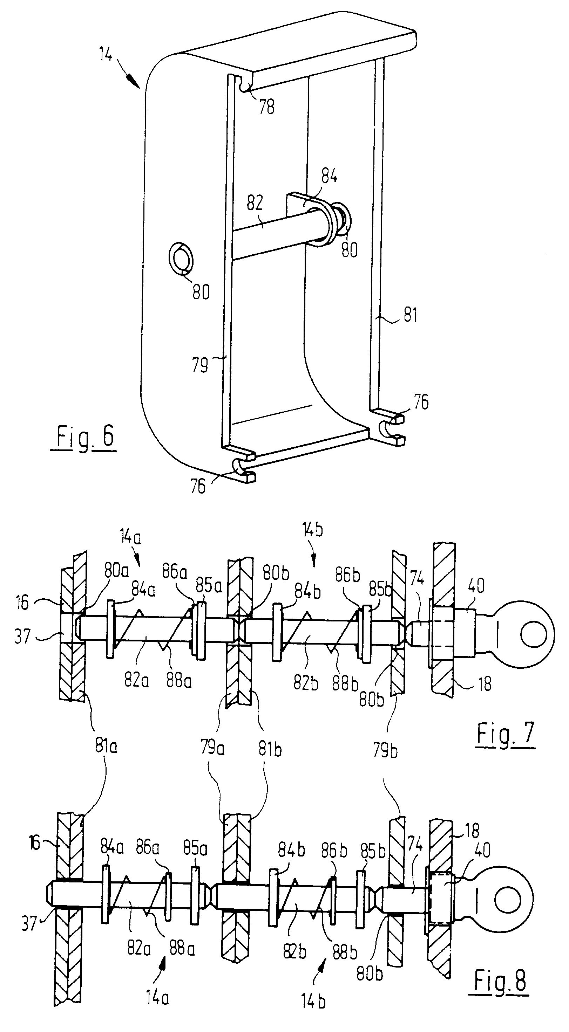

In Figur 6 ist die klappbare Seitenwand 14 dargestellt. Sie besitzt unten zwei klammerartige Elemente 76 zum Anlenken an dem Rahmenteil 10 und oben eine Rastkante 78 zum Einrasten in der Verschlußstellung in eine am Rahmenteil 10 ausgebildete Rastnut. Die Seitenwand 14 hat ein U-förmiges Profil, in dessen Schenkeln 79 und 81 fluchtende Öffnungen 80 vorgesehen sind. Zwischen den Öffnungen 80 ist ein stangenförmiger Schieber 82 an zwei Haltern 84, 85 in axialer Richtung verschieblich gelagert. Von den beiden Haltern 84, 85 ist in Figur 6 nur Halter 84 zu sehen. Der andere Halter 85 ist durch den Schenkel 79 der Seitenwand 14 verdeckt. Die Enden des Schiebers 82 schließen mit den Außenflächen der Schenkel 79, 81 ab. Die Schließfunktion dieses Mechanismus wird anhand der Figuren 7 und 8 näher beschrieben.

Figur 7 zeigt einen schematischen Querschnitt entlang des Schließmechanismus eines Gehäuses mit zwei in beschriebener Weise aneinander befestigten Rahmenteilen 10. Die Rückwand des Gehäuses sei von einer Montagewand 16 mit einer Bohrung 37 gebildet, die von dem Schieber 82a einer in Figur 7 links liegenden Seitenwand 14a durchsetzt werden kann. Der in den Haltern 84a, 85a gelagerte Schieber 82a besitzt einen fixen Anschlag 86a, an dem eine Feder 88a anliegt, deren anderes Ende an dem anderen Halter 84a anliegt. In dieser Stellung schließen die Enden des Schiebers 82a mit den Außenflächen der Schenkel 79a, 81a ab.

Wie in Figur 7 zu sehen ist, kommen beim Verschrauben mehrerer Rahmenteile 10 die Schieber 82a, b der Seitenwände 14a, b mit ihren Enden ungefähr aneinander zu liegen.

Das Gehäuse wird nach vorne durch eine Vorderwand 18 abgeschlossen, die einen Schließmechanismus 40 für die Seitenwände 14a, b besitzt. Der Schließmechanismus 40 hat einen Bolzen 74, der an den Schieber 82b der Seitenwand 14b anliegt.

In Figur 8 ist die Verschlußstellung des Schließmechanismus 40 für die Anordnung nach Figur 7 dargestellt. Hierbei durchsetzt der Bolzen 74 des Schließmechanismus 40 die Durchbohrung 80b des Schenkels 79b der Seitenwand 14b. Der Schieber 82b wird wiederum in die Öffnung 79a der Seitenwand 14a geschoben. Der Schieber 82a wiederum wird in die Durchbohrung 37 der Montagewand 16, die die Rückwand des Gehäuses bildet, geschoben. Auf diese Weise werden die Seitenwände 14a, b der Rahmenteile 10a, b in ihrer Verschlußstellung gehalten, und die Vorderwand 18 kann nicht mehr durch eine Bewegung quer zu den Gewindebolzen 28 vom Gehäuse gelöst werden, weil eine Bewegung in dieser Richtung durch den Eingriff des Bolzens 74 in die Öffnung 79b der Seitenwand 14b nicht mehr möglich ist.

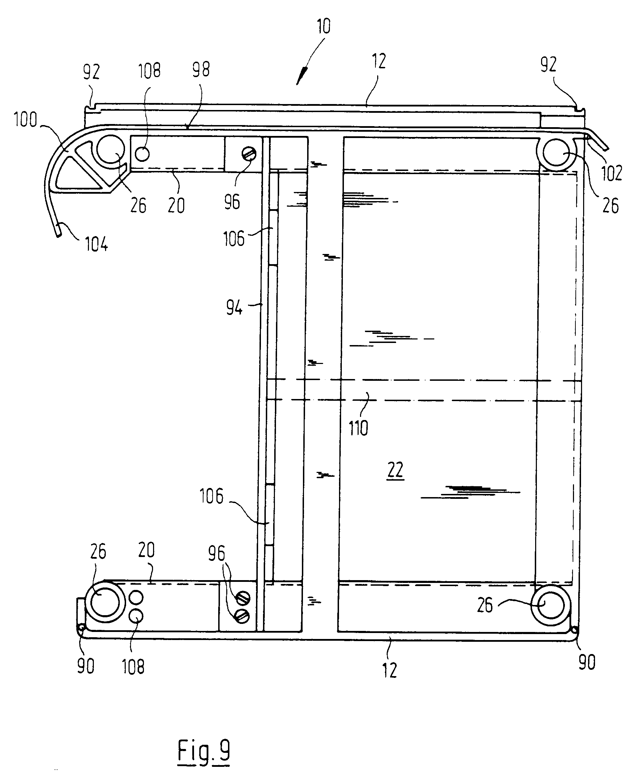

Figur 9 zeigt die Vorderansicht eines etwa quadratischen Rahmenteils 10. Es besitzt an seinen vier Ecken Durchstecköffnungen 26 zur Verbindung mit anderen Rahmenteilen 10 oder mit quer zu den Durchstecköffnungen 26 zu befestigenden Wänden 16, 18, 42. An den unteren Ecken sind zusätzlich kleine Zapfen 90 angeordnet, an denen eine Seitenwand 14 mit zwei in Figur 6 dargestellten klammerartigen Elementen 76 angelenkt werden kann. An den oberen Ecken des Rahmenteils 10 sind Rastnuten 92 als zu den Rastkanten 78 der Seitenwände 14, 15 komplementäre Rastelemente ausgebildet. In dem Rahmenteil 10 ist eine Verdrahtungswand 94 für einen Einschub (Figur 1) mit Schrauben 96 befestigt. Auf der Verdrahtungswand 94 sind Buchsenleisten 106 angebracht, über die der Einschub 22 mit der Verdrahtungswand 94 verbindbar ist. Die Verdrahtungswand 94 kann an mehreren Stellen des Rahmenteiles 10 befestigt werden. Beispielsweise können die Schrauben 96 auch in Gewindelöcher 108 eingeschraubt werden. Dadurch ist es möglich, Einschübe mit unterschiedlicher Tiefe zu verwenden. Im oberen Bereich des Rahmenteils ist eine Führungsnut 98 für ein Kabel ausgebildet. Die Führungsnut 98 endet in Kreissegmenten 100, 102, die eine Verkabelung auch von knickempfindlichen Kabeln wie z.B. Lichtleitkabel 104 ermöglichen. Kabel und Lichtleitkabel 104 können bei der Wandmontage eines Gehäusemoduls durch in der Montagewand 16 befindliche Öffnungen 17 (Figur 1) aus einer Wandleitung in das Gehäuse eingeführt werden.

Es ist auch denkbar, in die Durchbrechungen der Vorderwand 18, in denen die Schließvorrichtungen 40 mit den Schließbolzen 74 sitzen, Führungsbuchsen einzusetzen. Diese haben dann dieselbe Funktion wie die Durchbohrungen 38 in der Rückwand 42. Dadurch wird es möglich, ein und dasselbe Bauelement als Vorderwand 18 oder als Rückwand 42 zu verwenden.

Es ist ferner möglich, in dem Rahmenteil 10 parallel zu dessen Seitenwänden 12 eine Zwischenführung 110 vorzusehen, die zusammen mit den Führungen 20 das Einschieben zweier Einschübe nebeneinander gestattet. Diese Zwischenführung 110 ist in Figur 9 strichpunktiert dargestellt.

## Patentansprüche

1. Gehäusemodul für elektrische Baugruppen und/oder Anschlußvorrichtungen, mit einem quaderförmigen Rahmenteil (10) und mehreren an dem Rahmenteil (10) zu befestigenden Wänden (14, 15, 16, 18), wobei das Rahmenteil (10) mindestens zwei an der Innenseite diagonal einander gegenüber liegender Kanten parallel zu diesen liegende Durchstecköffnungen (26) zur Aufnahme jeweils eines Verbindungselementes (28) zur Verbindung mit einem weiteren Rahmenteil und/oder zur Befestigung einer Wand aufweist, dadurch **gekennnzeichnet**, daß das Rahmenteil (10) quer zu den Durchstecköffnungen (26) zueinander parallele innere Führungen (20) für mindestens eine Einschubeinheit (22) enthält, und daß an mindestens einer der parallel zu den Durchstecköffnungen (26) liegenden Kanten des Rahmenteils (10) mindestens eine Seitenwand (14) zwischen einer Öffnungsstellung und einer Verschlußstellung klappbar angelenkt ist.

2. Gehäusemodul nach Anspruch 1, dadurch **gekennzeichnet**, daß zwei einander gegenüber liegende Seitenwände (14, 15) klappbar angelenkt sind.

3. Gehäusemodul nach Anspruch 1 oder 2, dadurch **gekennzeichnet**, daß die klappbare Seitenwand (14, 15) ein U-förmiges Profil hat, dessen quer zu den Durchstecköffnungen (26) liegende Schenkel (79, 81) fluchtende Öffnungen (80) haben, in denen ein Schieber (82) gegen Federkraft verschieblich angeordnet ist, und daß eine quer zu den Durchstecköffnungen (26) zu befestigende Wand (16, 42) eine dem jeweiligen Schieber (82) entsprechend ausgebildete und angeordnete Öffnung (37, 38) enthält, während eine andere quer zu den Durchstecköffnungen (26) zu befestigende Wand (18) in entsprechender Anordnung je eine in Schieberichtung wirkende Schließvorrichtung (74) trägt.

4. Gehäusemodul nach einem der vorhergehenden Ansprüche, dadurch **gekennzeichnet**, daß in dem Rahmenteil (10) quer zu den inneren Führungen (20) eine Verdrahtungswand (94) für die Einschubeinheit (22) vorgesehen ist.

5. Gehäusemodul nach einem der vorhergehenden Ansprüche, dadurch **gekennzeichnet**, daß eine quer zu den Durchstecköffnungen (26) zu befestigende Wand als eine Montagewand (16) ausgebildet ist.

6. Gehäusemodul nach einem der vorhergehenden Ansprüche, mit Gewindebolzen (28) als Verbindungselemente, dadurch **gekennzeichnet**, daß quer zu den Durchstecköffnungen (26) zu befestigende Wände (16, 18, 42) an ihrer Innenseite in einer derjenigen der Durchstecköffnungen (26) entsprechenden Anordnung mit Gewindeelementen (34, 36, 46) ausgerüstet oder ausrüstbar sind.

7. Gehäusemodul nach Anspruch 6, dadurch **gekennzeichnet**, daß mindestens eine quer zu den Durchstecköffnungen (26) zu befestigende Wand (16, 18, 42) an ihrer Innenseite klauenartige Halter (44, 70) für Gewindeelemente (34, 46) trägt, deren Klauenöffnungen übereinstimmend ausgerichtet sind.

8. Gehäusemodul nach einem der vorhergehenden Ansprüche, mit Gewindebolzen (28) als Verbindungselemente, in deren Kopf (30) ein Innengewinde (32) vorgesehen ist, dadurch **gekennzeichnet**, daß die Durchstecköffnungen (26) erweiterte Enden haben, in die der Kopf (30) des jeweiligen Gewindebolzens (28) einsenkbar ist und darin mit einem Sicherungselement (54) versehen werden kann.

9. Gehäusemodul nach Anspruch 8, dadurch **gekennzeichnet**, daß die Enden der als Innenvielkant (60) ausgebildeten Durchstecköffnungen (26) um die Dicke eines zylindrischen Sicherungselementes (54) weiter als der Kopf (30) der Gewindebolzen (28) sind, und daß das Sicherungselement (54) eine dem Kopf (30) der Gewindebolzen (28) entsprechende Innenkontur und eine dem Innenvielkant (60) angepaßte Außenkontur hat.

10. Gehäusemodul nach Anspruch 9, dadurch **gekennzeichnet**, daß das Sicherungselement (54) eine Länge hat, die mindestens der doppelten Länge des erweiterten Endes der jeweiligen Durchstecköffnung (26) entspricht.

11. Gehäusemodul nach Anspruch 10, dadurch **gekennzeichnet**, daß das Sicherungselement (54) etwa in dem mittleren Abschnitt seiner Länge ein durchmessergrößeres flanschartiges Zylindersegment (62) hat.

## Claims

1. Housing module for electrical components and/or connection devices, having a cuboid frame part (10) and a plurality of walls (14, 15, 16, 18) to be attached to the frame part (10), said frame part (10) having at least two insertion openings (26) which are located on the inside of, and parallel to, edges located diagonally opposite one another for receiving a connecting element (28) in each case for connection to a further frame part and/or for attachment to a wall, characterised in that the frame part (10) contains inner guides (20), which run transversely to the insertion openings (26) and are parallel to one another, for at least one insertion unit (22), and in that at least one side wall (14) is linked to at least one of the edges of the frame part (10), located parallel to the insertion openings (26), so as to be pivotable between an opening position and a closed position.

2. Housing module according to Claim 1, characterised in that two side walls (14, 15), located opposite one another, are linked so as to be pivotable.

3. Housing module according to Claim 1 or 2, characterised in that the pivotable side wall (14, 15) has a U-shaped profile whose limbs (79, 81), located transversely to the insertion openings (26), have flush openings (80) in which a slide (82) is arranged so as to be displaceable counter to spring force, and in that a wall (16, 42), to be attached transversely to the insertion openings (26), contains an opening (37, 38) which is constructed and arranged so as to correspond to the respective slide (82), while another wall (18), to be attached transversely to the insertion openings (26), bears a closing device (74) in a corresponding arrangement in each case, said closing device acting in the sliding direction.

4. Housing module according to one of the preceding claims, characterised in that a wiring wall (94) for the insertion unit (22) is provided in the frame part (10) transversely to the inner guides (20).

5. Housing module according to one of the preceding claims, characterised in that a wall, to be attached transversely to the insertion openings (26), is constructed as an assembly wall (16).

6. Housing module according to one of the preceding claims, having threaded bolts (28) as connecting elements, characterised in that walls (16, 18, 42), to be attached transversely to the insertion openings (26), are equipped or can be equipped with threaded elements (34, 36, 46) on their inside in an arrangement corresponding to that of the insertion openings (26).

7. Housing module according to Claim 6, characterised in that at least one wall (16, 18, 42), to be attached transversely to the insertion openings (26), bears on its inside claw-type holders (44, 70) for threaded elements (34, 46), the claw openings of which claw holders are disposed in alignment.

8. Housing module according to one of the preceding claims, having threaded bolts (28) as connecting elements, in the head of which bolts (30) an internal thread (32) is provided, characterised in that the insertion openings (26) have widened ends into which the head (30) of the respective threaded bolt (28) can be sunk and can be provided therein with a securing element (54).

9. Housing module according to Claim 8, characterised in that the ends of the insertion openings (26), constructed as polygonal sockets (60), are wider by the thickness of a cylindrical securing element (54) than the head (30) of the threaded bolts (28), and in that the securing element (54) has an inner contour which corresponds to the head (30) of the threaded bolts (28) and an outer contour which is matched to the polygonal socket (60).

10. Housing module according to Claim 9, characterised in that the securing element (54) has a length which corresponds to at least twice the length of the widened end of the respective insertion opening (26).

11. Dousing module according to Claim 10, characterised in that, approximately in the central portion of its length, the securing element (54) has a flange-type cylindrical segment (62) which is larger in diameter.

## Revendications

1. Module de boîtier pour modules électriques et/ou dispositifs de raccordement, comportant un élément de cadre parallélépipédique (10) et plusieurs parois (14,15,16,18) devant être fixées à l'élément de cadre (10), ce dernier (10) possédant au moins deux ouvertures d'enfichage (26) qui sont situées à proximité du côté intérieur d'arêtes situées dans des positions réciproquement opposées en diagonale et parallèles à ces arêtes et servant à loger respectivement un élément de liaison (28) pour la liaison avec un autre élément de cadre et/ou pour la fixation d'une paroi, caractérisé par le fait que l'élément de cadre (10) comporte, pour au moins une unité formant tiroir (22), des guides intérieurs (20) parallèles entre eux et qui s'étendent transversalement par rapport aux ouvertures d'enfichage (26), et qu'au moins une paroi latérale (14) est articulée de manière à être rabattable entre une position ouverte et une position fermée, sur au moins l'une des arêtes de l'élément de cadre (10), qui est parallèle aux ouvertures d'enfichage (26).

2. Module de boîtier suivant la revendication 1, caractérisé par le fait que deux parois latérales (14,15) opposées l'une à l'autre sont articulées de manière à être rabattables.

3. Module de boîtier suivant la revendication 1 ou 2, caractérisé par le fait que la paroi latérale rabattable (14, 15) possède un profil en forme de U, dont les branches (79, 81), qui s'étendent transversalement par rapport aux ouvertures d'enfichage (26), possèdent des ouvertures alignées (80), dans lesquelles un poussoir (82) est disposé de manière à être déplaçable à l'encontre de la force d'un ressort, et qu'une paroi (16,42), qui doit être fixée transversalement aux ouvertures d'enfichage (26), présente une ouverture (37,38) agencée et disposée de manière à correspondre au poussoir respectif (82), tandis qu'une autre paroi (18), qui doit être fixée transversalement par rapport aux ouvertures d'enfichage (26), porte, selon une disposition correspondante, respectivement un dispositif de fermeture (74) agissant dans la direction de poussée.

4. Module de boîtier selon l'une des revendications précédentes, caractérisé par le fait qu'une paroi de câblage (94) pour l'unité formant tiroir (22) est prévue dans l'élément de cadre (10) transversalement par rapport aux guides intérieurs (20).

5. Module de boîtier suivant l'une des revendications précédentes, caractérisé par le fait qu'une paroi devant être fixée transversalement aux ouvertures d'enfichage (26) est agencée sous la forme d'une paroi de montage (16).

6. Module de boîtier suivant l'une des revendications précédentes, comportant des goujons filetés (28) en tant qu'éléments de liaison, caractérisé par le fait que des parois (16,18,42) devant être fixées transversalement par rapport aux ouvertures d'enfichage (26) sont pourvues ou peuvent être pourvues d'éléments filetés (34, 36, 46) sur leur face intérieure, selon une disposition qui correspond à celle des ouvertures d'enfichage (26).

7. Module suivant la revendication 6, caractérisé par le fait qu'au moins une paroi (16, 18, 42) devant être fixée transversalement par rapport aux ouvertures de passage (26) porte, sur sa face intérieure, des éléments de retenue en forme de griffes (44, 70) pour des éléments filetés (34, 46), les ouvertures des griffes étant alignées de manière à être coïncidantes.

8. Module de boîtier suivant l'une des revendications précédentes, comportant des goujons filetés (28) en tant qu'éléments de liaison, dans la tête desquels (30) est prévu un taraudage (32), caractérisé par le fait que les ouvertures d'enfichage (26) possèdent des extrémités élargies, dans lesquelles la tête (30) du goujon fileté respectif (28) peut être enfoncée et peut être pourvue, en cet endroit, d'un élément de sécurité (54).

9. Module de boitier suivant la revendication 8, caractérisé par le fait que les extrémités des ouvertures d'enfichage (26) réalisées sous la forme d'un élément polyédrique creux (60) sont surélevées, de l'épaisseur d'un élément de sécurité cylindrique (54), par rapport à la tête (30) des goujons filetés (28), et que l'élément de sécurité (54) possède un contour intérieur, qui correspond à la tête (30) des goujons filetés (28), et un contour extérieur adapté à l'élément polyédrique creux.

10. Module de boîtier suivant la revendication 9, caractérisé par le fait que l'élément de sécurité (54) possède une longueur qui correspond au moins au double de la longueur de l'extrémité élargie de l'ouverture d'enfichage respective (26).

11. Module de boîtier suivant la revendication 10, caractérisé par le fait que l'élément de sécurité (54) possède, approximativement dans la section médiane de sa longueur, un segment de cylindre (62) du type en forme de bride, possédant un diamètre accru.
